Europäisches Patentamt

European Patent Office

Office européen des brevets

(19)

(11) Veröffentlichungsnummer: **0 232 477**
**B1**

(12) **EUROPÄISCHE PATENTSCHRIFT**

(45) Veröffentlichungstag der Patentschrift:
14.02.90

(21) Anmeldenummer: 86115674.3

(22) Anmeldetag: **12.11.86**

(51) Int. Cl.⁴: **C22F 1/10**, C30B 1/02,
C30B 29/52, H05B 6/02

(54) Verfahren zum Zonenglühen eines metallischen Werkstücks.

(30) Priorität: **19.12.85  CH 5427/85**

(43) Veröffentlichungstag der Anmeldung:
**19.08.87 Patentblatt 87/34**

(45) Bekanntmachung des Hinweises auf die Patenterteilung:
**14.02.90 Patentblatt 90/7**

(84) Benannte Vertragsstaaten:
**CH DE FR GB LI SE**

(56) Entgegenhaltungen:
**EP-A- 0 158 844
FR-A- 1 148 889
FR-A- 1 562 821
FR-A- 2 146 716
FR-A- 2 527 650
GB-A- 637 008
GB-A- 710 426
GB-A- 768 441
US-A- 3 746 581**

(73) Patentinhaber: **BBC Brown Boveri AG, Haselstrasse,
CH-5401 Baden(CH)**

(72) Erfinder: **Jongenburger, Peter, Röthlerholzstrasse 6,
CH-5406 Rütihof-Baden(CH)**

## Beschreibung

Die Erfindung geht aus von einem Verfahren zum Zonenglühen zur Erzeugung längsgerichteter Stengelkristalle in einem metallischen Werkstück nach der Gattung des Oberbegriffs des Anspruchs 1.

Zur Erzielung bestimmter, in bevorzugter Richtung orientierter Kristallstrukturen werden Werkstücke zonengeglüht. Dabei wird in der Regel das eine ausgeprägte Längsachse aufweisende Werkstück, in welchem längsorientierte Stengelkristalle erzeugt werden sollen, in der Längsachse relativ zu einer Wärmequelle verschoben. Es können grundsätzlich 3 verschiedene herkömmliche Verfahrenstypen des Zonenglühens unterschieden werden:

A). Hindurchführen des Werkstücks durch eine Induktionsspule (induktive Heizung), wobei ein grosser Temperaturgradient in der Längsrichtung auftritt: Das Temperatur/Vorschub-Schaubild zeigt einen Kurvenverlauf mit steilen Flanken vor und nach der Induktionsspule und einem schmalen, steilen Maximum auf der Höhe derselben (Vergl. DE-A-2 219 275).

B). Hindurchlaufenlassen des Werkstücks durch einen Ofen mit im Verhältnis zur Werkstückquerabmessung grösseren Länge, wobei ein vergleichsweise kleiner Temperaturgradient in der Längsrichtung auftritt. Das Temperatur/Vorschub-Schaubild zeigt einen Kurvenverlauf mit flachen Flanken am Ein- und Austritt des Ofens und einem flachen, breiten Maximum in der Mitte desselben (Vergl. Cairns et al. Met. Trans. A 6A, 1975, 179).

C). Vertikales Eintauchen des Werkstücks in ein Salzbad, wobei ein einseitiger Temperaturgradient auf der Eintrittseite auftritt: Das Temperatur/Vorschub-Schaubild zeigt einen Kurvenverlauf mit einem mittleren, dann abflachenden Anstieg, gefolgt von einem annähernd horizontalen Stück bei maximaler Werkstück-temperatur.

Die vorgenannten Methoden eignen sich in der Regel nur für kleine Werkstücke von wenigen cm² Querschnitt. Bei grösseren Werkstücken kann der notwendige Temperaturgradient in der Längsrichtung nicht erreicht werden und die Vorschubgeschwindigkeiten sind zu niedrig für eine wirtschaftliche Fertigung.

Es besteht daher ein Bedürfnis nach einer Verbesserung der Zonenglühprozesse.

Der Erfindung liegt die Aufgabe zugrunde, ein Zonenglühverfahren anzugeben, mit welchem sich hohe Temperaturen im Kern des Werkstücks, hohe Temperaturgradienten in Längsrichtung auf der Aufheizseite und hohe Vorschubgeschwindigkeiten erzielen lassen.

Diese Aufgabe wird durch die im Anspruch 1 angegebenen Merkmale gelöst.

Der Grundgedanke besteht dabei darin, durch entsprechende Anbringung von Wärmequellen und einen gezielt gesteuerten Wärmefluss für eine rasche Durchwärmung des Werkstückquerschnitts mit damit verbundenem hohen Temperaturgradienten in Längs- (Vorschub-) Richtung des Werkstücks zu sorgen. Dies wird erreicht durch rasche Aufheizung in der Eintrittzone mittels einer Induktionsspule und Konservierung der Wärme (Wärmestau) in einer anschliessenden Zone mit Wärmeisolation oder Zusatzheizung mittels eines Ofens. Dadurch wird der longitudinale Wärmefluss in Vorschubrichtung nach Durchlaufen der eigentlichen Aufheizzone vermieden während der radiale Wärmefluss innerhalb der letzteren verstärkt wird.

Die Erfindung wird anhand der nachfolgenden, durch Figuren näher erläuterten Ausführungsbeispiele beschrieben.

Dabei zeigt:

Fig. 1 ein Temperatur/Vorschub-Schaubild des Verfahrens,
Fig. 2 einen Schnitt durch eine schematische Vorrichtung mit Isolierkörper zur Durchführüng des Verfahrens,
Fig. 3 einen Schnitt durch eine Vorrichtung mit Ofen zur Durchführung des Verfahrens,
Fig. 4 einen Schnitt durch eine Vorrichtung mit Wasserbad und Ofen zur Durchführung des Verfahrens.

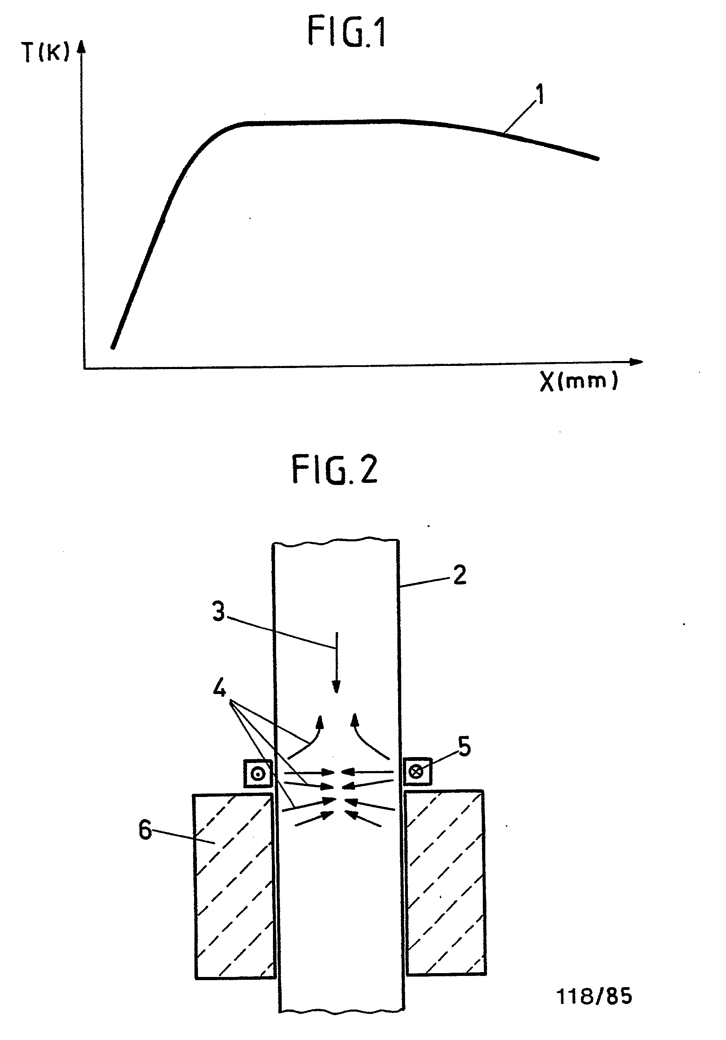

In Fig. 1 ist ein Temperatur/Vorschub-Schaubild des Verfahrens dargestellt. 1 ist die Temperatur T in Funktion des Vorschubes X (Ortsfunktion) in Längsrichtung des Werkstücks. Die Temperatur steigt zunächst steil an, um dann in ein flaches, breites Maximum überzugehen und danach wieder leicht abzufallen. Dieser Temperaturverlauf ist für die Erzielung eines langgestreckten Grobkorns von grösster Wichtigkeit.

Fig. 2 zeigt einen Schnitt durch eine schematische Vorrichtung mit Isolierkörper zur Durchführung des Verfahrens. 2 ist ein Werkstück (Stab mit kreisförmigem, rechteckigem, polygonalem, ovalem oder beliebigem anderen Querschnitt, z.B. Turbinenschaufel), welcher senkrecht nach unten bewegt wird. 3 deutet die Vorschubrichtung des Werkstücks 2 an. Die Pfeile 4 bedeuten den Wärmefluss im Inneren des Werkstücks 2. 5 ist eine Heizwicklung (Induktionsspule) für konzentrierte induktive Erwärmung des Werkstücks 2. 6 ist ein Isolierkörper, welcher den Wärmefluss im Werkstück 2 in der Querrichtung nach Durchlaufen der heissesten Zone begrenzt.

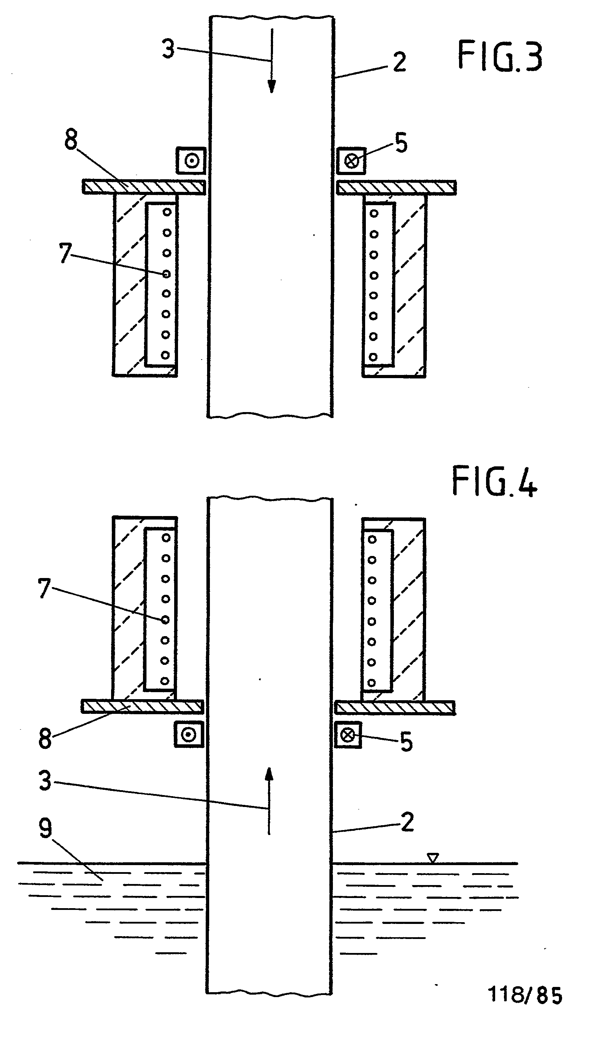

In Fig. 3 ist ein Schnitt durch eine schematische Vorrichtung mit Ofen zur Durchführung des Verfahrens dargestellt. 7 ist ein Ofen beliebiger Art, der das Werkstück 2 auf seinem ganzen Mantel umschliesst, im vorliegenden Fall z.B. als elektrischer Widerstandsofen angedeutet. 8 ist eine Abdeckplatte. Die übrigen Bezugszeichen entsprechen genau denjenigen der Figur 2.

Fig. 4 bezieht sich auf einen Schnitt durch eine schematische Vorrichtung mit Wasserbad und Ofen zur Durchführung des Verfahrens. Das Werkstück 2 wird hier vertikal nach oben bewegt. 9 ist ein Wasserbad. Die übrigen Be zugszeichen sind die gleichen wie in Fig. 3.

Ausführungsbeispiel 1:

(Siehe Fig. 1 und Fig. 3)

Ein langgestreckter Barren aus einer dispersionsgehärteten Nickelbasis-Superlegierung wurde zonengeglüht. Der Werkstoff mit dem Handelsnamen MA 6000 hatte die nachfolgende Zusammensetzung:

| Cr | = | 15 | Gew.-% |
|------|---|------|--------|
| W | = | 4 | Gew.-% |
| Mo | = | 2 | Gew.-% |
| Al | = | 4,5 | Gew.-% |
| Ti | = | 2,5 | Gew.-% |
| Ta | = | 2,0 | Gew.-% |
| C | = | 0,05 | Gew.-% |
| B | = | 0,01 | Gew.-% |
| Zr | = | 0,15 | Gew.-% |
| $Y_2O_3$ | = | 1,1 | Gew.-% |

Der Barren hatte die folgenden Abmessungen:

| Dicke | = | 30 mm |
|--------|---|-------|
| Breite | = | 150 mm (Profilradius zirka 38 mm) |
| Länge | = | 1000 mm |

Der Barren wurde gemäss Diagramm Fig. 1 in einer Vorrichtung ähnlich Fig. 3 wärmebehandelt. Zu diesem Zweck wurde er mit einer konstanten Vorschubgeschwindigkeit von 4 mm/min vertikal in die Vorrichtung abgesenkt. Der Ofen hatte eine Temperatur von 1275°C. Die Aufheizgeschwindigkeit in der Mitte des Werkstücks für eine Temperatur von 1160°C betrug ca. 43°C/min. Der Temperatur gradient in der Mitte in Längsrichtung erreichte den Wert von 10,6°C/mm.

Nach dem Abkühlen wurde das Gefüge untersucht. Die in Längsrichtung gestreckten Körner wiesen durchschnittlich eine Länge von 20 mm, eine Breite von 0,3 mm und eine Dicke von 0,3 mm auf.

Ausführungsbeispiel 2:

(Siehe Fig. 1 und Fig. 3)

Ein länglicher Rundbarren von 40 mm Durchmesser und 500 mm Länge aus dem Werkstoff mit dem Handelsnamen MA 6000 und der Zusammensetzung gemäss Beispiel 1 wurde zonengeglüht. Dabei wurde genau gleich wie unter Beispiel 1 angegeben vorgegangen. Die konstante vertikale Vorschubgeschwindigkeit betrug 8 mm/min, die Ofentemperatur 1270°C, die Aufheizgeschwindigkeit bei 1160°C ca. 80°C/min, der Temperaturgradient in Längsrichtung ca. 10°C/mm.

Ausführungsbeispiel 3:

(Siehe Fig. 1 und Fig. 2)

Ein Barren aus dem Werkstoff MA 6000 mit genau der gleichen Zusammensetzung und den gleichen Abmessungen wie unter Beispiel 1 angegeben, wurde zonengeglüht. An die Stelle des Ofens 7 (Fig. 3) trat der Isolierkörper 6 (Fig. 2). Die Vorschubgeschwindigkeit in vertikaler Richtung betrug 6 mm/min, die Aufheizgeschwindigkeit für eine Temperatur von 1160°C ca. 50°C/min, der Temperaturgradient in Längsrichtung ca. 8°C/mm.

Das längsgestreckte Grobkorn hatte durchschnittlich eine Länge von 20 mm, eine Breite von 0,3 mm und eine Dicke von 0,3 mm.

Aüsfuhrungsbeispiel 4:

(Siehe Fig. 1 und Fig. 4)

Ein langgestreckter Barren aus einer pulvermetallurgisch hergestellten Nickelbasis-Superlegierung wurde zonengeglüht. Der Werkstoff PM-IN 939 hatte die nachfolgende Zusammensetzung:

| Al | = | 3,7 | Gew.-% |
|----|---|-----|--------|
| Co | = | 19 | Gew.-% |
| Cr | = | 22,5 | Gew.-% |
| Fe | = | 0,5 | Gew.-% |
| Ta | = | 1,4 | Gew.-% |
| Ti | = | 5 | Gew.-% |
| Zr | = | 0,1 | Gew.-% |
| Ni | = | Rest | |

Die Abmessungen waren die gleichen wie unter Beispiel 1. Der Barren wurde gemäss Diagramm Fig. 1 in einer Vorrichtung ähnlich Fig. 4 wärmebehandelt. Er wurde mit einer konstanten Vorschubgeschwindigkeit von 7 mm/min vertikal aus einem Wasserbad von durchschnittlich 50°C herausgezogen. Der Ofen hatte eine Temperatur von 1275°C Die Aufheizgeschwindigkeit für eine Temperatur von 1000°C betrug ca. 100°C/min, der Temperaturgradient in Längsrichtung bei 700°C ca. 25°C/mm und bei 1150°C ca. 10°C/mm.

Das Grobkorn hatte durchschnittlich eine Länge von 23 mm, eine Breite von 0,3 mm und eine Dicke von 0,3 mm.

Die Erfindung ist nicht auf die Ausführungsbeispiele beschränkt. Der Temperatur/Weg-Gradient in der Aufheizzone beträgt vorzugsweise 7 bis 20°C/mm, das flache Maximum der Temperatur in der Temperatur/Orts-Funktion 80 bis 400 % gemessen am mittleren Profilradius des Werkstücks. Der Temperatur/Weg-Gradient des abfallenden Astes nach Durchlaufen des Temperaturmaximums weist vorteilhafterweise eine geringe Neigung von 0 bis 1°C/mm im Werkstück auf. Dieser Teil des Schaubildes kann also auch horizontal verlaufen. Die Temperatur des Ofens wird vorzugsweise so gewählt, dass sie um 0 bis 80°C unter der dem Werkstück aufgedrückten maximalen Temperatur liegt.

$$Profilradius = \sqrt{\frac{Querschnittsfläche}{\pi}} \ .$$

## Patentansprüche

1. Verfahren zum Zonenglühen zur Erzeugung längsgerichteter Stengelkristalle in einem metallischen Werkstück (2), dessen Querschnitt einen Profilradius von mindestens 10 mm aufweist, wobei letzteres sukzessive in Vorschubrichtung (3) durch eine Zone höherer Temperatur hindurchgeführt wird, dadurch gekennzeichnet, daß der Prozeß derart geführt wird, dass die Temperatur (1) in Funktion des Weges in Vorschubrichtung (3) des Werkstücks (2) gesehen zunächst steil ansteigt, indem der Temperatur/Weg-Gradient im Werkstück (2) in Funktion des Ortes in der Aufheizzone 7 bis 20°C/mm beträgt, ein flaches Maximum mit einer Breite von 80 bis 400% gemessen am mittleren Profilradius des Werkstücks (2) durchläuft und dann mit geringer Neigung mit einem Temperatur/Weg-Gradienten von 0 bis 1°C/mm im Werkstück (2) abfällt, wobei

$$Profilradius = \sqrt{\frac{Querschnittsfläche}{\pi}} \ .$$

2. Verfahren nach Anspruch 1, dadurch gekennzeichnet, dass das Werkstück (2) sukzessive durch eine induktive Heizwicklung (5) und dicht anschließend durch einen Ofen (7) hindurchgeführt wird, dessen Temperatur um 0 bis 80°C unter der dem Werkstück (2) aufgedrückten maximalen Temperatur liegt.

3. Verfahren nach Anspruch 1, dadurch gekennzeichnet, dass das Werkstück (2) sukzessive durch eine induktive Heizwicklung (5) und dicht anschließend durch einen profilierten hohlen Isolierkörper (6) hindurchgeführt wird.

4

EP 0 232 477 B1

4. Verfahren nach Anspruch 1, dadurch gekennzeichnet, dass das Werkstück (2) zunächst durch ein kühlendes Wasserbad (9) und anschließend sukzessive durch eine induktive Heizwicklung (5) und dicht anschliessend durch einen Ofen (7) hindurchgeführt wird.

**Claims**

1. Method for zone heat treatment to obtain longitudinally directed columnar crystals in a metallic workpiece (2), whose cross-section has a profile radius of at least 10 mm, the workpiece being passed successively in the feed direction (3) through a zone of higher temperature, characterized in that the process is carried out in such a way that the temperature (1) − considered as a function of the displacement in the feed direction (3) of the workpiece (2) − initially rises steeply, the temperature/displacement gradient in the workpiece (2) as a function of the location in the heating zone being between 7 and 20°C/mm, passes through a flat maximum having a width of between 80 and 400% measured relative to the average profile radius of the workpiece (2), and then falls with a small slope having a temperature/displacement gradient of between 0 and 1°C/mm in the workpiece (2), where

$$\text{Profile radius} = \sqrt{\frac{\text{Cross/sectional area.}}{\pi}}$$

2. Method according to claim 1, characterized in that the workpiece (2) is passed successively through an inductive heating winding (5) and immediately thereafter through a furnace (7) whose temperature is between 0 and 80°C under the maximum temperature to which the workpiece (2) is subjected.

3. Method according to claim 1, characterized in that the workpiece (2) is passed successively through an inductive heating winding (5) and immediately thereafter through a profiled hollow insulating body (6).

4. Method according to claim 1, characterized in that the workpiece (2) is passed initially through a cooling water bath (9) and thereafter successively through an inductive heating winding (5) and immediately thereafter through a furnace (7).

**Revendications**

1. Procédé de recuit par zones pour la production de cristaux basaltiques orientés en direction longitudinale dans une pièce métallique (2), dont la section présente un rayon de profil d'au moins 10 mm, dans lequel cette pièce est conduite successivement en direction d'avancement (3) à travers une zone de température plus élevée, caractérisé en ce que le processus est conduit de telle manière que la température (1) augmente d'abord brusquement en fonction du chemin parcouru, vu dans la direction d'avancement (3) de la pièce (2), le gradient de température/chemin dans la pièce (2) valant de 7 à 20 °C/mm selon la position dans la zone d'échauffement, franchisse un maximum plat avec une largeur de 80 à 400%, mesuré au rayon du profil moyen de la pièce (2) et diminue ensuite avec une faible pente avec un gradient température/chemin de 0 à 1°C/mm dans la pièce (2), avec la condition

$$\text{rayon du profil} = \sqrt{\frac{\text{aire de la section}}{\pi}} \quad \cdot$$

2. Procédé suivant la revendication 1, caractérisé en ce que la pièce (2) est conduite successivement à travers un enroulement de chauffage inductif (5) et immédiatement ensuite à travers un four (7), dont la température se situe 0 à 80°C en dessous de la température maximale appliquée à la pièce (2).

3. Procédé suivant la revendication 1, caractérisé en ce que la pièce (2) est conduite successivement à travers un enroulement de chauffage inductif (5) et immédiatement ensuite à travers un corps isolante profilé creux (6).

4. Procédé suivant la revendication 1, caractérisé en ce que la pièce (2) est conduite d'abord à travers un bain aqueux de refroidissement (9) et ensuite successivement à travers un enroulement de chauffage inductif (5) et immédiatement ensuite à travers un four (7).

5

# FIG.1

# FIG.2

118/85

FIG.3

3

2

8

5

7

FIG.4

7

8

5

3

9

2